# EUROPEAN PATENT APPLICATION

(11) **EP 2 650 925 A1**
(43) Date of publication of application: **16.10.2013**
(21) Application number: 11847407.1
(22) Date of filing: 30.11.2011
(51) Int. Cl.: H01L 31/04, G01R 31/26

(54) **SOLAR CELL OUTPUT MEASURING DEVICE AND MEASURING METHOD**

(30) Priority: 07.12.2010 JP 2010272838; 01.11.2011 JP 2011240174
(71) Applicant: Dexerials Corporation, Tokyo 141-0032 (JP)
(72) Inventor: SHIN, Yasumasa, Tokyo 141-0032 (JP); SUGA, Yasuhiro, Tokyo 141-0032 (JP); HIGUCHI, Akifumi, Tokyo 141-0032 (JP); OKUMIYA, Hideaki, Tokyo 141-0032 (JP)
(74) Representative: Müller - Hoffmann & Partner
(86) International application number: PCT/JP2011/077690
(87) International publication number: WO 2012/077556

(57) **Abstract**

The present invention accurately measures the electrical characteristics even of a solar cell having a busbarless structure. The present invention is provided with a terminal plate (2) made of a conductor that simultaneously contacts a plurality of finer electrodes (31) by means of intersecting the finger electrodes (31) over the plurality of finger electrodes (31), which are formed on the surface of the solar cell (20). The terminal plate (2) is connected to a measuring device (6) that measures the electrical characteristics of the solar cell (20), and the terminal plate (2) is formed into a rectangular shape, and one surface thereof (2b) forms a surface that contacts the finger electrodes (31).

## Description

### Field of the Invention

This invention relates to an output measuring device for measuring electrical characteristics of a solar cell and a measuring method thereof, and in particular concerns improvements of an electrode terminal structure that is made in contact with the solar cell.
The present application asserts priority rights based on JP Patent Application 2010-272838 filed in Japan on December 7, 2010 and JP Patent Application 2011-240174 filed in Japan on November 1, 2011. The total contents of disclosure of the Patent Application of the senior filing date are to be incorporated by reference into the present Application.

### Background of the Invention

Conventionally, as a measuring device for measuring electrical characteristics of a solar cell, in general, a measuring device provided with a plurality of probe pins that are made in contact with busbar electrodes of the solar cell has been used. The measuring device of this type is provided with current measuring probe pins for use in measuring an electric current flowing through the solar cell and voltage measuring probe pins for use in measuring a voltage generated in the solar cell.

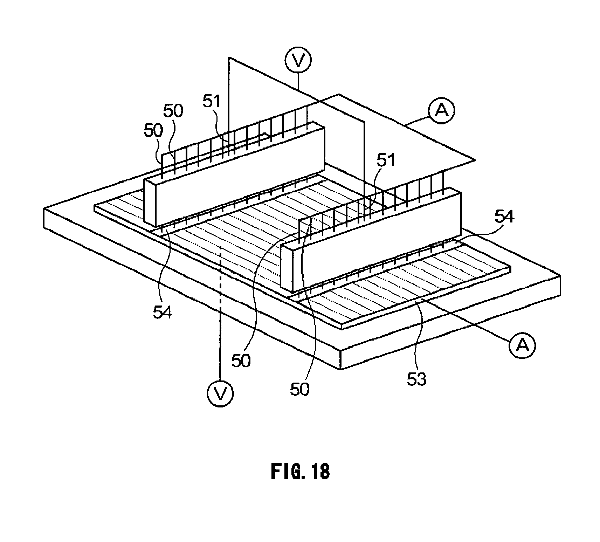

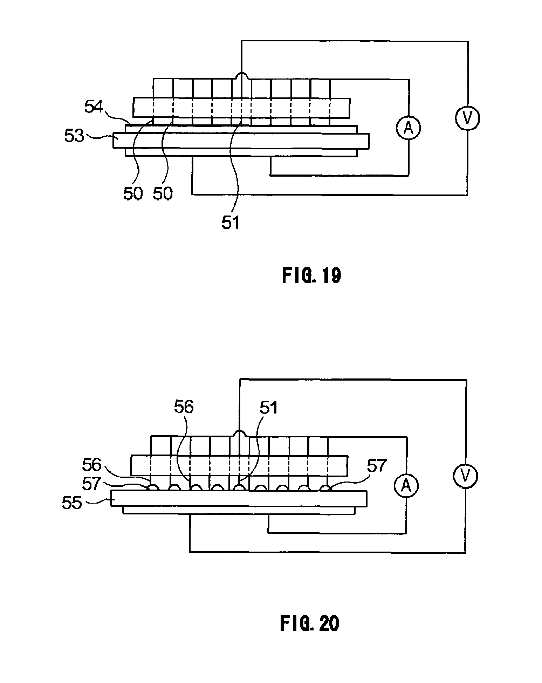

Upon carrying out measurements of electrical characteristics on a solar cell, for example, as shown in Figs. 18 and 19, these current measuring probe pins 50 and voltage measuring probe pins 51 are made in contact with busbar electrodes 54 of a solar cell 53 to be measured, and while irradiating the light receiving surface of the solar cell 53 with pseudo solar light, a current flowing through the solar cell 53 and a voltage generated in the solar cell 53 are measured, that is, a so-called 4-terminal method is carried out.

### Prior-Art Documents

### Patent Document

PTL 1: Japanese Patent Application Laid-Open No. 2006-118983

### Summary of the Invention

In recent years, in order to reduce the number of production processes of a solar cell and also to cut the used amount of electrode materials, such as Ag paste and the like, and subsequently reduce production costs, a technical method has been proposed in which without forming busbar electrodes, tab wires are directly adhered to finger electrodes in a manner so as to intersect the finger electrodes, with a conductive adhesive film interpolated therebetween. In such a solar cell having the busbarless structure as well, current collecting efficiency as high as, or higher than that of the solar cell with the busbar electrodes formed therein can be obtained.

In the case when electrical characteristics are measured on such a solar cell 55 having the busbarless structure, probe pins 56 need to be directly made in contact with finger electrodes 57. However, as shown in Fig. 20, the interval between the standing probe pins 56 formed and the interval between positions at which the finger electrodes 57 are formed are not coincident with each other in many cases, and in this case, it is not possible to make all the finger electrodes 57 conductive, with the result that there are some finger electrodes 57 that are not subjected to the measurements to cause a failure in carrying out accurate measurements of electrical characteristics.

Therefore, an object of the present invention is to provide a solar cell output measuring device and an output measuring method for a solar cell that can carry out accurate measuring processes for electrical characteristics even on such a solar cell having the busbarless structure.

In order to solve the above-mentioned problems, a solar cell output measuring device in accordance with the present invention is provided with a terminal plate made of a conductor that is allowed to intersect a plurality of finger electrodes formed on a surface of a solar cell so as to be simultaneously made in contact with the plural finger electrodes, and the terminal plate is connected to a measuring device for measuring electrical characteristics of the solar cell and formed into a rectangular shape, with one surface thereof being allowed to form a contact surface with the finger electrodes.

Moreover, a solar cell output measuring method in accordance with the present invention, which is a method that uses a solar cell output measuring device provided with a terminal plate made of a conductor and having a rectangular shape, which is connected to a measuring device for use in measuring electrical characteristics of a solar cell is provided with processes in which by placing one surface of the terminal plate on a plurality of finger electrodes formed on a surface of the solar cell so as to intersect the finger electrodes, the terminal plate is simultaneously made in contact with the plural finger electrodes, and while irradiating the surface of the solar cell with light, electrical characteristics thereof are measured.

### Effects of Invention

In accordance with the present invention, the contact surface of the terminal plate is made in surface-contact with the finger electrodes; therefore, upon measuring electrical characteristics of a solar cell having a busbarless structure, the terminal is allowed to be positively made in contact with all the finger electrodes so that it is possible to measure the electrical characteristics with high precision. Brief Description of Drawings

Figure 1 is a perspective view showing an essential portion of a solar cell measuring device to which the present invention is applied.
Figure 2 is a side face view showing electrode terminals.
Figures 3A and 3B are perspective views that explain a joined state of two terminal plates of the electrode terminals.
Figure 4 is an exploded perspective view showing solar cells and a solar cell module.
Figure 5 is a cross-sectional view showing solar cells.
Figure 6 is a bottom face view showing a rear surface of each solar cell.
Figure 7 is a cross-sectional view showing a conductive adhesive film.
Figure 8 is a view that explains a measuring process of a solar cell measuring device.
Figure 9 is a view that explains a measuring process of the solar cell measuring device.
Figure 10 is a cross-sectional view showing another solar cell in which a solar cell measuring device 1 is used.
Figure 11 is a plan view showing a thermal compression region and a non-thermal compression region.
Figure 12 is a perspective view showing a state in which electrical characteristics of the other solar cell are measured by using the solar cell measuring device 1.
Figures 13A and 13B are plan views that show solar cells relating to an example and a comparative example.
Figure 14 is a graph that shows distributions of measured values of photoelectric conversion efficiency of solar cells by the example and the comparative example.
Figure 15 is a perspective view that shows a solar cell measuring device relating to another structure of the present invention.
Figure 16 is a side view that shows the solar cell measuring device relating to the other structure of the present invention.
Figure 17 is a perspective view showing an auxiliary jig relating to the example.
Figure 18 is a perspective view showing a state in which electrical characteristics of a solar cell are measured by using a conventional measuring device in which probe pins are used.
Figure 19 is a view for use in explaining measuring processes by the use of the conventional measuring device in which probe pins are used.
Figure 20 is a view for use in explaining measuring processes of electrical characteristics of a solar cell having a busbarless structure by the use of the conventional measuring device in which probe pins are used.

### Detailed Description of the Invention

Referring to Figures, the following description will discuss a solar cell output measuring device to which the present invention is applied and an output measuring method for a solar cell, in detail.

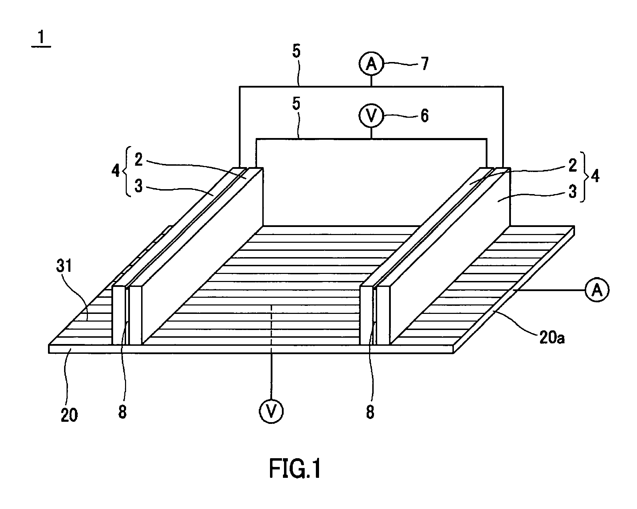

As shown in Fig. 1, this solar cell output measuring device 1 is provided with two sets of electrode terminals 4, each set having a voltage measuring terminal plate 2 and a current measuring terminal plate 3 that are combined with each other as one pair. The voltage measuring terminal plate 2 of each of the electrode terminals 4 is connected to each other with a cable 5, and is also connected to a voltmeter 6. In the same manner, the current measuring terminal plate 3 of each of the electrode terminals 4 is connected to each other with the cable 5, and is also connected to an ampere meter 7.

### [Electrode Terminal]

The electrode terminal 4 has a structure in which the voltage measuring terminal plate 2 and the current measuring terminal plate 3 are integrally formed as one unit with an insulating layer 8 interpolated therebetween. The voltage measuring terminal plate 2 has a function for measuring voltage characteristics of a solar cell 20 by being made in contact with a plurality of finger electrodes 31 formed in the solar cell 20 to be described later, in a manner so as to intersect therewith. Moreover, the current measuring terminal plate 3 has a function for measuring current characteristics of the solar cell 20 by being made in contact with the plural finger electrodes 31 formed in the solar cell 20, in a manner so as to intersect therewith.

Each of these voltage measuring terminal plate 2 and current measuring terminal plate 3 is made of a conductor, and can be formed by using, for example, metal such as Cu, Al or the like. Moreover, both of the voltage measuring terminal plate 2 and current measuring terminal plate 3 are formed into the same rectangular plate shape, and integrally formed, with respective main surfaces 2a and 3a being opposed to each other and with an insulating layer 8 being interpolated therebetween.

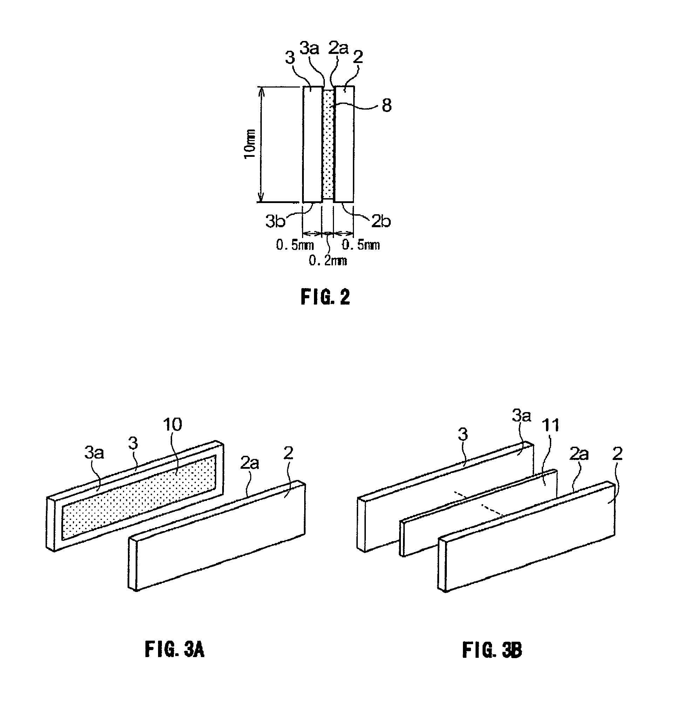

More specifically, as shown in Fig. 2, the respective terminal plates 2 and 3 allow their surfaces adjacent to each other, with one side in the longitudinal direction of the main surface portion 2a being interposed therebetween, to serve as contact surfaces 2b and 3b with the solar cell 20, and the respective contact surfaces 2b and 3b are formed so as to have the same height. Therefore, the electrode terminals 4 make the respective contact surfaces 2b and 3b in contact with the surface of the solar cell 20 simultaneously as well as positively.

The dimensions of the respective portions of the terminal plates 2 and 3 are, for example, given as 0.5 mm in the width of each of the contact surfaces 2b and 3b, 10 mm in the height of the main surface portions 2a and 3a, and 0.2 mm in the thickness of the insulating layer 8. Additionally, the contact area of the electrode terminal 4 to the surface of the solar cell 20 including the widths of the contact surfaces 2b and 3b to which the thickness of the insulating layer 8 is added is preferably set to the same as the width of a conventional general-use busbar electrode or less than the width thereof. With this structure, at the time of measuring electrical characteristics, it is possible to suppress the shadow loss of the electrode terminal 4 to the same level as that of a conventional solar cell using busbar electrodes.

Moreover, the length in the longitudinal direction of each of the contact surfaces 2b and 3b is set to at least the same length as the length of one side 20a in a direction orthogonal to the formation direction of each finger electrode 31 of the solar cell 20. Therefore, the electrode terminal 4 allows the respective contact surfaces 2b and 3b to be made in contact with all the finger electrodes 31 formed on the solar cell 20 in a manner so as to intersect therewith. In this case, the respective terminal plates 2 and 3 may have the lengths in the longitudinal direction of the contact surfaces 2b and 3b set to be longer than the length of one side 20a of the solar cell 20.

Moreover, in the respective terminal plates 2 and 3, at least the contact surfaces 2b and 3b of conductor surfaces to the solar cell may be subjected to a rust preventive plating process by using a material having conductivity, such as Au, solder or the like, or preferably, the rust preventive plating process may be carried out over the entire surface of the conductor surface.

The insulating layer 8 interpolated between the respective main surfaces 2a and 3a of these voltage measuring terminal plate 2 and current measuring terminal plate 3 is used for insulating the two terminal plates 2 and 3 from each other. For example, as shown in Fig. 3A, the insulating layer 8 is formed by processes in which after applying an adhesive agent 10 having an insulating property to one of the respective main surfaces 2a and 3a of the two terminal plates 2 and 3, or to both of them, the two terminal plates 2 and 3 are pasted to each other. Moreover, as shown in Fig. 3B, the insulating layer 8 may be formed by placing an adhesive film 11 having an insulating property between the two main surfaces 2a and 3a and curing the insulating adhesive film 11. Furthermore, the insulating layer 8 may be formed by using an adhesive tape (not shown) having no curing property, on demand.

### [Adhesive Agent]

As these insulating adhesive agent 10 and insulating adhesive film 11, a conventionally known insulating resin adhesive composition for use in, for example, configuring electronic parts on a substrate may be used, and for example, an epoxy-based curing resin composition and an acryl-based curing resin composition, or products formed by molding these materials into films may be proposed. Among these, those of a thermosetting type may be preferably used.

The epoxy-based thermosetting resin composition is composed of a compound or a resin, for example, having two or more epoxy groups in a molecule, an epoxy curing agent, a film-forming component, etc.

As the compound or resin having two or more epoxy groups in a molecule, any of a liquid-state material or a solid-state material may be used, and examples thereof include bifunctional epoxy resins, such as a bisphenol A-type epoxy resin and a bisphenol F-type epoxy resin, and novolak-type epoxy resins, such as a phenol novolak-type epoxy resin and a cresol novolak-type epoxy resin. Moreover, alicyclic epoxy compounds, such as 3,4-epoxycyclohexenylmethyl-3',4'-epoxycyclohexene carboxylate, may also be used.

As the epoxy curing agent, examples thereof include: amine-based curing agents, imidazole-based curing agents, acid anhydride-based curing agents, sulfonium cation-based curing agents, etc. The curing agent may be a potential curing agent.

As the film-forming component, examples thereof include a phenoxy resin and an acrylic resin that are compatible with an epoxy compound and an epoxy resin.

The epoxy-based thermosetting resin composition may contain a known curing accelerator, a silane coupling agent, a metal capturing agent, a stress relaxing agent such as butadiene rubber or the like, an inorganic filler such as silica, a polyisocyanate-based crosslinking agent, a colorant, an antiseptic agent, a solvent and the like, if necessary.

The acryl-based thermosetting resin composition is composed of, for example, a (meth)acrylate monomer, a film-forming resin, an inorganic filler such as silica or the like, a silane coupling agent, a radical polymerization initiator, etc.

As the (meth)acrylate monomer, a monofunctional (meth)acrylate monomer, a polyfunctional (meth)acrylate monomer, or a modified monofunctional or polyfunctional (meth)acrylate monomer obtained by introducing an epoxy group, a urethane group, an amino group, an ethylene oxide group, a propylene oxide group or the like to those monomers may be used. Moreover, as long as the effects of the present invention are not impaired, another monomer that is radical copolymerizable with (meth)acrylate monomer, for example, (meth)acrylic acid, vinyl acetate, styrene, vinyl chloride or the like may be used in combination.

As the film-forming resin for the acryl-based thermosetting resin composition, examples thereof include: a phenoxy resin, a polyvinyl acetal resin, a polyvinyl butyral resin, an alkylated cellulose resin, a polyester resin, an acrylic resin, a styrene resin, a urethane resin, a polyethylene terephthalate resin, or the like, may be used.

As the radical polymerization initiator, an organic peroxide, such as benzyl peroxide, dicumyl peroxide, dibutyl peroxide, or the like, and an azobis-based compound, such as azobisisobutyronitrile and azobisisovaleronitrile, may be used.

The acryl-based thermosetting resin composition may contain a stress relaxing agent such as butadiene rubber, a solvent such as ethyl acetate, a colorant, an oxidation inhibitor, an antioxidant, and the like, if necessary.

The molding process of these epoxy-based thermosetting resin composition and acryl-based thermosetting resin composition into an insulating resin adhesive film (NCF) may be carried out by using a conventionally known method.

### [Measuring Method]

Next, the following description will discuss processes for measuring electrical characteristics of the solar cell 20 by the use of the solar cell output measuring device 1.

### [Structure of Solar Cell]

First, the following description will discuss the solar cell 20 on which the measuring processes for electrical characteristics are carried out by the solar cell output measuring device 1. The solar cell 20 has a structure in which, without busbar electrodes being formed, each of tab wires 21 forming interconnectors is directly adhered to finger electrodes 31 in a manner so as to intersect therewith, and the solar cell output measuring device 1 is desirably used for the measurements of the solar cell 20 having such a busbarless configuration.

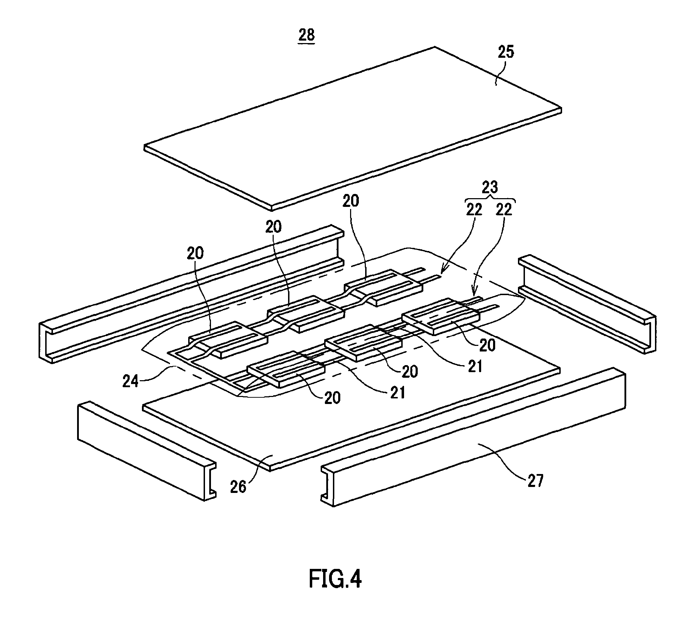

As shown in Fig. 4, the solar cells 20 are series or parallel connected to each other by the tab wires 21 forming the interconnectors so that each string 22 is formed. A plurality of strings 22 are arranged to form a matrix 23, and this matrix 23, which is sandwiched by sheets 24 made of a sealing adhesive agent, is laminated as one unit together with a surface cover 25 formed on a light-receiving surface side and a back sheet 26 formed on a rear surface side, and lastly, a metal frame 27 made of aluminum or the like is attached to the peripheral portion so that a solar cell module 28 is formed.

As the sealing adhesive agent, for example, a translucent sealing material, such as an ethylene vinyl acetate resin (EVA) or the like, is used. Moreover, as the surface cover 25, for example, a translucent material, such as glass and a translucent plastic material, is used. As the back sheet 26, a laminate member or the like in which glass or an aluminum foil is sandwiched by resin films is used.

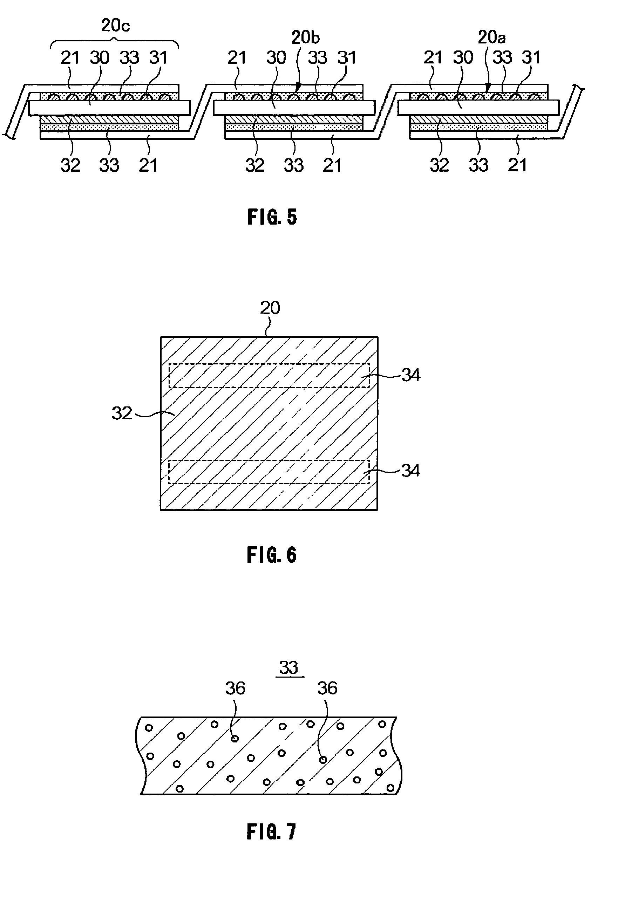

As shown in Fig. 5, each of the solar cells 20 of the solar cell module is provided with a photoelectric conversion element 30. As the photoelectric conversion element 30, various kinds of photoelectric conversion elements 30, such as a crystal silicon-based solar cell using a monocrystal-type silicon photoelectric conversion element or a polycrystal- type photoelectric conversion element, and a thin-film silicon-based solar cell using a photoelectric conversion element in which a cell made of amorphous silicon and a cell made of microcrystal silicon or amorphous silicon germanium are stacked on each other, may be used.

Moreover, the photoelectric conversion element 30 is provided with finger electrodes 31 that collect electricity generated inside thereof on its light-receiving surface side. The finger electrodes 31 are formed through processes in which, after an Ag paste has been applied onto the surface of the solar cell 20 forming the light-receiving surface by a screen printing method or the like, a baking process is carried out thereon. Moreover, the finger electrodes 31 are formed over the entire surface of the light-receiving surface as a plurality of lines, each having a width of, for example, about 50 to 200 *µ* m, that are virtually in parallel with one another with a predetermined interval of, for example, 2 mm, and tab wires 21 are connected to all the finger electrodes 31 in a manner so as to intersect therewith by a conductive adhesive film 33.

Furthermore, the photoelectric conversion element 30 is provided with a rear surface electrode 32, made of aluminum or silver, which is formed on a rear surface side opposite to the light-receiving surface. As shown in Figs. 4 and 6, the rear surface electrode 32 is prepared as an electrode made of aluminum or silver that is formed on the rear surface of each solar cell 20 by using, for example, a screen printing method, a sputtering method, or the like. The rear surface electrode 32 has tab wire connecting portions 34 to which the tab wire 21 is connected, with the conductive adhesive film 33 interpolated therebetween, which will be described later.

In each solar cell 20, the respective finger electrodes 31 formed on the surface thereof are electrically connected to the rear surface electrode 32 of an adjacent solar cell 20 by the tab wire 21 so that strings 22 that are series-connected with one after another are formed. The tab wire 21, the finger electrodes 31 and the rear surface electrode 32 are connected to one another by the conductive adhesive film 33.

As shown in Fig. 5, the tab wire 21 is made of a conductive base member having an elongated shape that is used for electrically connecting adjacent solar cells 20a, 20b and 20c with one another, and for example, is formed by using a ribbon-shaped copper foil having virtually the same width as that of the conductive adhesive film 33 to be described later, with a thickness of, for example, 50 to 300 *µ* m, with a gold plating, silver plating, tin plating, solder plating process or the like being carried out thereon, if necessary.

### [Adhesive Film]

As shown in Fig. 7, the conductive adhesive film 33 is a thermosetting binder resin layer that contains conductive particles 36 at a high density.

Although not particularly limited, as the conductive particles 36 used for the conductive adhesive film 33, examples thereof include: metal particles such as nickel, gold, silver and copper, resin particles that are subjected to gold plating, and those resin particles that are subjected to gold plating, with their outermost layer being coated with an insulating material.

Although not particularly limited, the composition of the binder resin layer of the conductive adhesive film 33 preferably contains a film-forming resin, a liquid-state epoxy resin, a potential curing agent and a silane coupling agent.

Moreover, with respect to the conductive adhesive film 33, two films for use as surface electrodes and two films for use as rear surface electrodes, which are formed into predetermined lengths, are temporarily pasted onto predetermined positions on the surface and rear surface of the solar cell 20. In this case, the conductive adhesive films 33 are temporarily pasted onto the surface of the solar cell 2 so as to be virtually orthogonal to the respective plural finger electrodes 31 that are formed on the surface of the solar cell 2 virtually in parallel with one another.

In the same manner, the tab wires 21, which are cut into predetermined lengths, are disposed on the conductive adhesive films 33 in an overlapped manner thereon. Thereafter, each conductive adhesive film 33 is thermally compressed onto the tab wires 21 at predetermined temperature and pressure by a heating bonder so that the binder resin is hardened and the conductive particles 36 are simultaneously sandwiched between the tab wires 21 and the finger electrodes 31 or the rear surface electrode 32. Thus, each conductive adhesive film 33 allows the tab wires 21 to be adhered onto the respective electrodes and also to be conductively connected with one another.

Additionally, in the above embodiment, explanations have been given by exemplifying a structure using the conductive adhesive film 33; however, not limited to a film-shaped conductive adhesive agent, a paste-state conductive adhesive agent may be used.

The measuring processes of electrical characteristics of the solar cell 20 by the use of the solar cell output measuring device 1 are carried out at the time when the finger electrodes 31 and the rear surface electrode 32 have been formed on the photoelectric conversion element 30. More specifically, the solar cell 20 is placed on a mounting base, and the electrode terminal 4 of the solar cell output measuring device 1 is made in contact with predetermined positions of the cell surface. As shown in Fig. 1, the electrode terminal 4 is disposed so that the respective contact surfaces 2b and 3b of the voltage measuring terminal plate 2 and the current measuring terminal plate 3 are made orthogonal to all the finger electrodes 31. Moreover, the electrode terminal 4 allows the voltage measuring terminal plate 2 to be connected to the voltmeter 6 and the current measuring terminal plate 3 to be also connected to the ampere meter 7 respectively by cables 5.

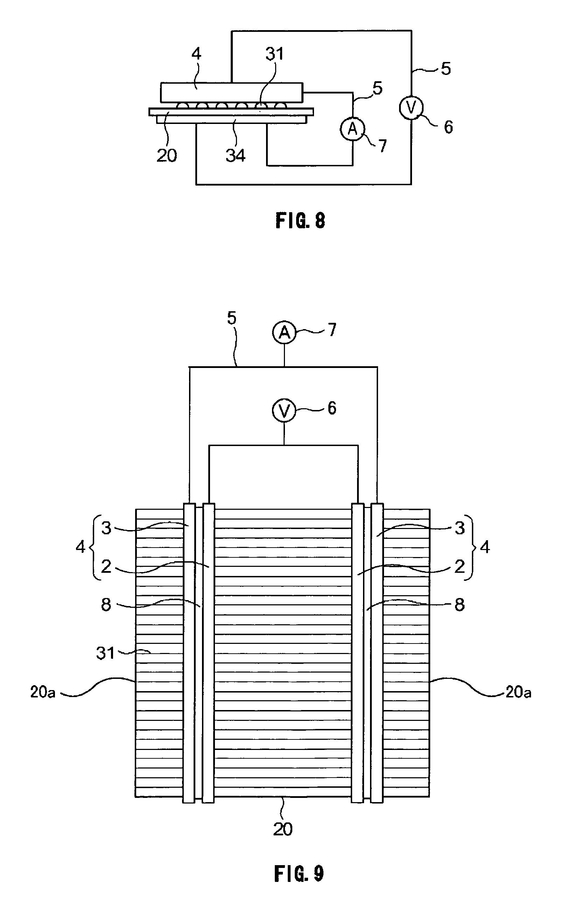

Moreover, the solar cell output measuring device 1 has a circuit configuration as shown in Figs. 8 and 9, and makes it possible to carry out measurements of electrical characteristics on the solar cell 20 by irradiating the two surfaces of the cells with pseudo solar light, by using a so-called 4-terminal method. At this time, in accordance with the solar cell output measuring device 1, since the contact surface of the electrode terminal 4 formed into a rectangular plate shape is made in contact with the surface of the solar cell 20, all the finger electrodes 31 are made in contact with the contact surfaces 2b and 3b of the electrode terminal 4. Therefore, in accordance with the solar cell output measuring device 1, upon measuring electrical characteristics of the solar cell 20 of the busbarless structure, since the electrode terminal 4 is positively made in contact with all the finger electrodes 31, it is possible to measure the electrical characteristics with high precision.

### [Another Embodiment 1]

Moreover, in addition to measurements of electrical characteristics of the solar cell 20 of the busbarless structure, the solar cell output measuring device 1 may be used for measuring electrical characteristics of a solar cell 41 in which collector electrodes 40 that intersect with the finger electrodes 31 are formed on the outside edge portions thereof. In the following description, those members having the same structures as those of the above-mentioned solar cell 20 are indicated by the same reference numerals, and the description thereof will be omitted.

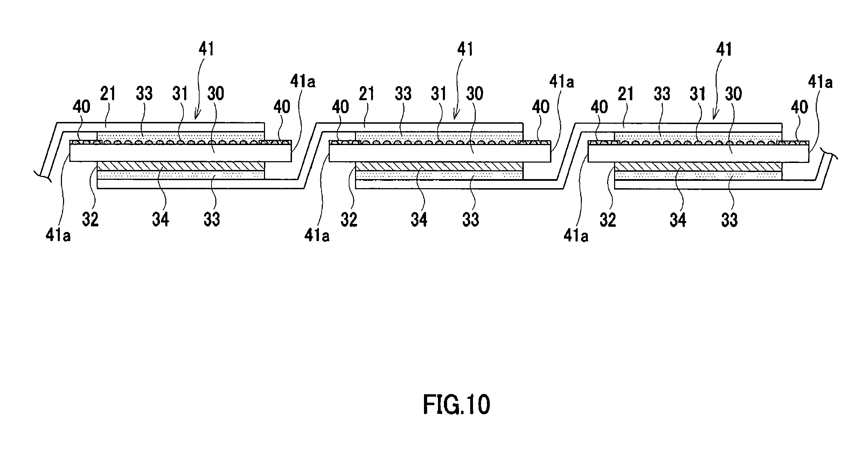

As shown in Fig. 10, the solar cell 41 has a structure in which in order to prevent generation of a stress at the time of thermally compressing the tab wires 21 and the conductive adhesive film 33 and subsequent so-called cell cracks caused by the stress applied onto the solar cell 41 due to a difference in linear expansion coefficients between the solar cell 41 and the tab wires 21 or expansion and shrinkage due to heating and cooling, a thermal compression region of the tab wires 21 that is exerted onto the solar cell 41 by a heating bonder is offset from the outside edge portion 41 a of the solar cell 41 toward the center side of the cell.

Therefore, in the solar cell 41, since the tab wires 21 are not thermally compressed onto the outside edge portion 41 a side, the finger electrodes 31 and the tab wires 21 formed on the outside edge portion 41 a side are not connected each other for conduction. However, in this state, current is not collected from the finger electrodes 31 formed on the outside edge portion 41a side to cause a current collection loss, and the subsequent reduction in the photoelectric conversion efficiency.

For this reason, in the solar cell 41, a collector electrode 40 that is orthogonal to the finger electrodes 31 installed near the outside edge portion 41a is formed over a non-thermal compression region 4 1 c in which the tab wires 21 are not thermally compressed by the heating bonder and the edge portion of a thermal compression region 41b in which the tab wires 21 are thermally compressed by the heating bonder. The collector electrode 40 is formed through processes in which, for example, an Ag paste is applied to a predetermined position of the surface electrodes by a screen printing process or the like, and baked thereon.

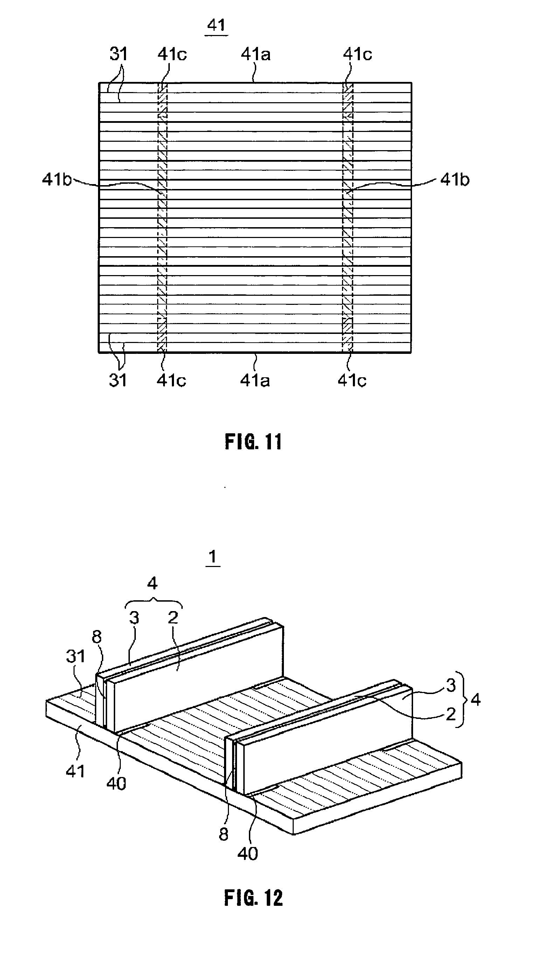

The thermal compression region 41b and the non-thermal compression region 41 c are referred to as regions located between the outside edge portions 41a that are opposed to each other on the solar cell 41 on which the conductive adhesive film 33 and the tab wires 21 are disposed and adhered thereto, and as shown in Fig. 11, of the corresponding regions, the thermal compression region 41b corresponds to a region that is offset from each of the two outside edge portions 41 a toward the cell inner side where the thermal compressing process of the tab wires 21 onto the solar cell 41 is carried out by a heating bonder, and of the corresponding regions, the non-thermal compression region 41c corresponds to a region on the outside edge portion 41a side from the thermal compression region 41b.

The collector electrode 40 is used for collecting current from the finger electrodes 31 on the non-thermal compression region 41c in which the tab wires 21 are not thermally compressed, and is formed across the non-thermal compression region 41 c and the end portion of the thermal compression region 41 b, and connected to the tab wires 21 that are adhered to the thermal compression region 41b.

With this structure, the solar cell 41 carries out current collection from the finger electrodes 31 in the thermal compression region 41 b by using the tab wires 21, and also carries out current collection from the finger electrodes 31 in the non-thermal compression region 41c by using the collector electrode 40. Therefore, the solar cell 41 makes it possible to prevent generation of current collection loss in the non-thermal compression region 41c, and also to make the photoelectric conversion efficiency the same as or higher than that of a solar cell in which busbar electrodes are formed over the entire regions of the thermal compression region 41b and non-thermal compression region 41c. Moreover, since the thermal compression region 41b of the tab wires 21 is offset from each of the outside edge portions 41 a toward the inner side, the solar cell 41 is free from fear of occurrence of cell cracks due to a stress applied to the outside edge of the cell. Furthermore, since the solar cell 41 makes it possible to reduce the used amount of a silver paste for use as a material for the busbar electrodes in comparison with a solar cell in which the busbar electrodes are formed over the entire regions of the thermal compression region 4 1 b and non-thermal compression region 41 c, and consequently to reduce the production costs.

The solar cell output measuring device 1 carries out the measuring processes of this solar cell 41 in the same manner as in the solar cell 20 at the time when the finger electrodes 31, the rear surface electrodes 32 and the collector electrodes 40 have been formed on the photoelectric conversion element 30. More specifically, as shown in Fig. 12, in the solar cell 41, the respective contact surfaces 2b and 3b of the voltage measuring terminal plate 2 and the current measuring terminal plate 3 of the electrode terminal 4 of the solar cell output measuring device 1 are made in contact with the thermal compression region 41b and the non-thermal compression region 41 c.

With this structure, the voltage measuring terminal plate 2 and the current measuring terminal plate 3 are connected to the finger electrodes 31 formed on the thermal compression region 41b in a manner so as to be orthogonal thereto, and also connected to the finger electrodes 31 formed on the non-thermal compression region 41 c through the collector electrode 40. Therefore, in accordance with the solar cell output measuring device 1, even in the case of measuring electrical characteristics of the solar cell 41 provided with the collector electrode 40 that is formed on the finger electrodes 31 of the non-thermal compression region 41c across the non-thermal compression region 41 c and the end portion of the thermal compression region 41b on each of the outside edge portions 41a, since the electrode terminal 4 is positively made in contact with all the finger electrodes 31, it is possible to measure the electrical characteristics with high precision.

### Example 1

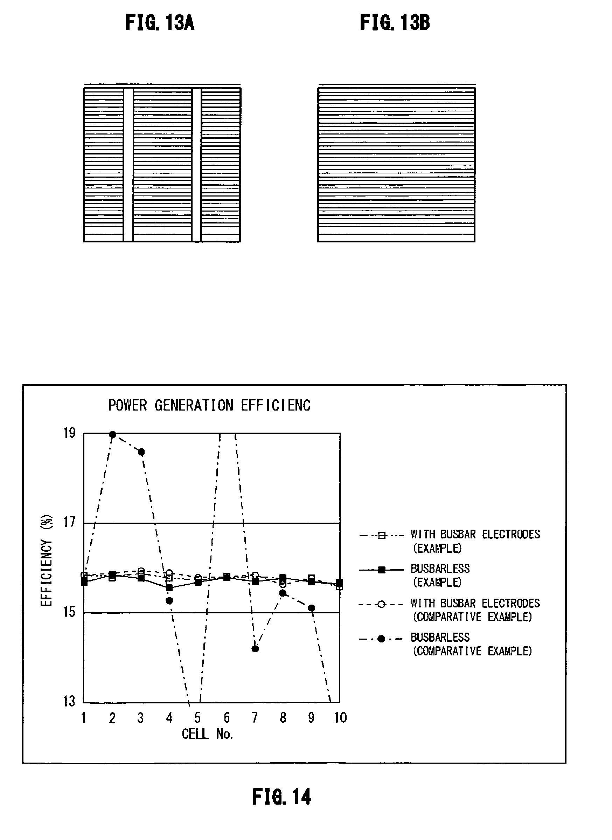

Next, the following description will discuss examples in which, by using the solar cell output measuring device 1, the photoelectric conversion efficiency is measured on a solar cell (sample 1) in which general busbar electrodes are formed, as shown in Fig. 13A, as well as on a solar cell (sample 2) which has a busbarless structure as shown in Fig. 13B, in comparison with measurements (comparative example) carried out by an output measuring device provided with measuring terminals having a conventional probe-pin structure.

The measurements of the photoelectric conversion efficiency by the output measuring devices relating to the example and comparative example were carried out 10 times respectively on both of a generally-used solar cell (sample 1) and a solar cell (sample 2) having the busbarless structure so that a standard deviation (∑) was found.

In the measurements on the sample 1, the photoelectric conversion efficiency was measured, with the electrode terminal 4 or the probe pins being made in contact onto the busbar electrodes. With respect to the sample 2 having the busbarless structure, the photoelectric conversion efficiency was measured, with the electrode terminal 4 or the probe pins being made in contact onto a plurality of finger electrodes. The measurements of the respective photoelectric conversion efficiencies were conducted under conditions of an illuminance of 1000 W/m², a temperature of 25°C and a spectrum of AM 1.5G, by using a solar simulator (PVS1116i, made by Nisshinbo Mechatronics, Inc.). The results of the measurements are shown in Table 1 and Fig. 14.

**[Table 1]**

| Cell No. | | Example | Comparative Example |
|---|---|---|---|
| | | Power generation efficiency (%) | Power generation efficiency (%) |
| With busbar electrodes | 1 | 15.819 | 15.851 |
| | 2 | 15.804 | 15.855 |
| | 3 | 15.867 | 15.941 |
| | 4 | 15.765 | 15.911 |
| | 5 | 15.752 | 15.795 |
| | 6 | 15.782 | 15.796 |
| | 7 | 15.814 | 15.848 |
| | 8 | 15.725 | 15.649 |
| | 9 | 15.763 | 15.777 |
| | 10 | 15.607 | 15.638 |
| | Ave | 15.770 | 15.806 |
| | ∑ | 0.070 | 0.100 |
| Busbarless | 1 | 15.693 | 15.750 |
| | 2 | 15.842 | 18.969 |
| | 3 | 15.768 | 18.601 |
| | 4 | 15.556 | 15.287 |
| | 5 | 15.687 | 11.832 |
| | 6 | 15.797 | 21.112 |
| | 7 | 15.713 | 14.197 |
| | 8 | 15.765 | 15.461 |
| | 9 | 15.712 | 15.117 |
| | 10 | 15.674 | 11.998 |
| | Ave | 15.721 | 15.832 |
| | ∑ | 0.079 | 2.976 |

As shown in Table 1 and Fig. 14, in accordance with the measurements (example) by the solar cell output measuring device 1, the sample 1 had a standard deviation of 0.070 and the sample 2 had a standard deviation of 0.079 so that deviations in the measured values were comparatively small. In contrast, in the measurements (comparative example) by the conventional output measuring device using the probe pins, the sample 1 had a standard deviation of 0.100, but the sample 2 had a standard deviation of 2.976, with the result that deviations in the measured values were large.

This is because in the case of the comparative example, the interval between the probe pins and the interval between the finger electrodes are not coincident with each other in the sample 2, with the result that the number of the finger electrodes with which the probe pins are made in contact differs for every measurements. Therefore, it is found that in the comparative example, the measurements for electrical characteristics can be carried out in a comparatively stable manner on the conventional solar cell on which the busbar electrodes are formed, while it is not possible to carry out the measurements for electrical characteristics on the solar cell 20 having the busbarless structure.

On the other hand, in accordance with the example, the standard deviation of the measured values of the sample 1 and the sample 2 is close to 0, indicating that it is possible to carry out the measurements of electrical characteristics stably irrespective of the electrode structure of the solar cell.

### [Another Embodiment 2]

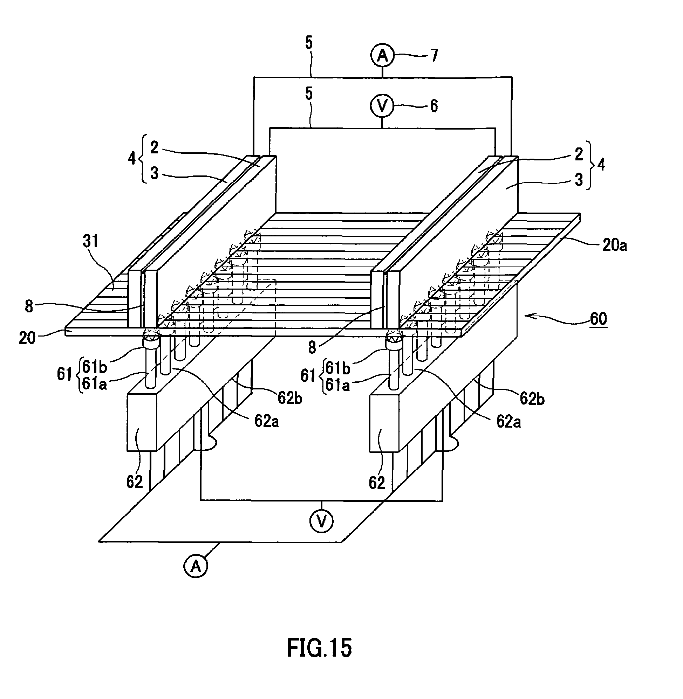

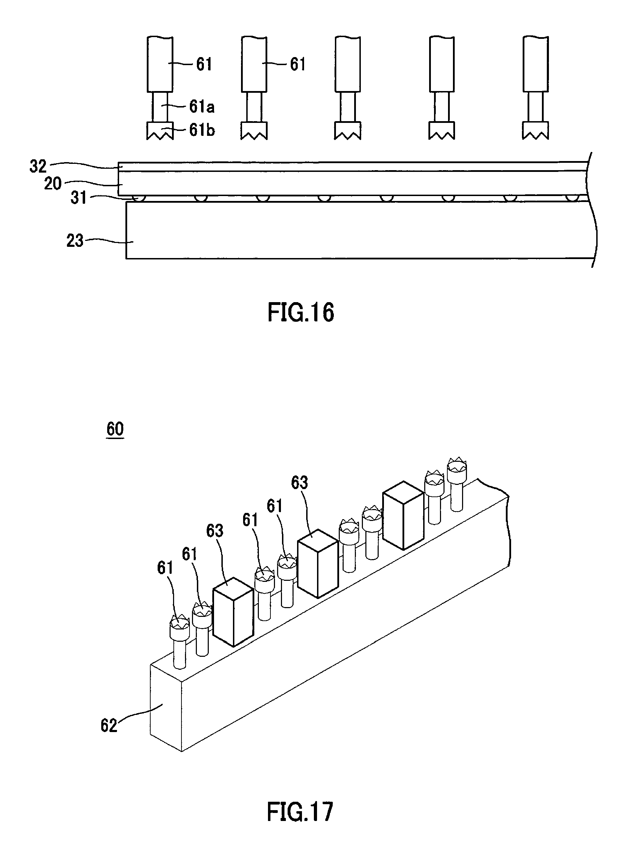

Next, the following description will discuss still another embodiment of a solar cell output measuring device and a solar cell output measuring method in accordance with the present invention. In the solar cell output measuring device in accordance with the present embodiment, in addition to an electrode terminal 4 in which the aforementioned voltage measuring terminal plate 2 and current measuring terminal plate 3 are combined with each other as one pair, as shown in Figs. 15 and 16, an auxiliary jig 60 that sandwiches a solar cell 20 in cooperation with the electrode terminal 4 formed on the rear surface side of the solar cell 20 is installed.

By compressing the solar cell 20 from the rear surface side, the auxiliary jig 60 ensures a contact of the rectangular plate-shaped voltage measuring terminal plate 2 and current measuring terminal plate 3 to the finger electrodes 31 formed on the surface of the solar cell 20 so as to accurately carry out measurements of electrical characteristics. That is, the above-mentioned electrode terminal 4 has both of its voltage measuring terminal plate 2 and current measuring terminal plate 3 formed into rectangular plate shapes, with the contact surfaces 2b and 3b to the finger electrodes 31 being formed into flat shapes. On the other hand, the finger electrodes 31 formed on the solar cell 20 have deviations in heights, with the result that the respective contact surfaces 2b and 3b of the voltage measuring terminal plate 2 and current measuring terminal plate 3 are not made in contact with all the finger electrodes 31, possibly failing to carry out accurate measurements. Therefore, in the present embodiment, the auxiliary jig 60 that presses the solar cell 20 from the rear surface side is placed, and the solar cell 20 is sandwiched by the auxiliary jig 60 and the voltage measuring terminal plate 2 as well as the current measuring terminal plate 3 so that the respective contact surfaces 2b and 3b of the voltage measuring terminal plate 2 and the current measuring terminal plate 3 are made in contact with all the finger electrodes 31.

As shown in Fig. 15, the auxiliary jig 60 is provided with a plurality of probe pins 61 that press the rear surface electrode 32 formed on the rear surface of the solar cell 2 and a holder 62 that supports the probe pins 61.

Each probe pin 61 has a pin main body 61a that is held by the holder 62 and a contact portion 6 1 b that is attached onto a tip of the pin main body 61a and made in contact with the rear surface of the solar cell 20. The pin main body 61a is formed into a column shape, and the contact portion 61 b is formed into a column shape having a larger diameter than that of the pin main body 61a. The probe pin 61 has such a structure that, with the pin main body 61a being held by the holder 62, the contact portion 61b is allowed to protrude from the upper surface 62a of the holder 62.

The holder 62 that holds the probe pins 61 is formed into a rectangular plate shape by using, for example, a resin material such as glass epoxy, acrylic resin, polycarbonate resin, or the like. Each of the upper and lower surfaces 62a and 62b of the holder 62 is composed of a longer side having a length corresponding to the length of one side of the solar cell 20 and a shorter side having a width on which at least one row of the probe pins 61 are arranged with an even interval. Moreover, the plural probe pins 61 are embedded into the holder 62 in a direction perpendicular to the upper and lower surfaces.

Moreover, the auxiliary jig 60 is supported by a shifting mechanism, not shown, so as to be freely raised and lowered so that it can come close to or depart from the rear surface of the solar cell 20. Upon measuring electrical characteristics of the solar cell 20, the auxiliary jig 60 sandwiches the surface and rear surface of the solar cell 20 in cooperation with the electrode terminal 4. With this structure, even in the case when there are irregularities on the finger electrodes 31, it is possible to make the voltage measuring terminal plate 2 and the current measuring terminal plate 3 of the electrode terminal 4 in contact with all the finger electrodes 31.

The auxiliary jig 60 is preferably placed at a position opposed to the electrode terminal 4 with the solar cell 20 interposed in between. With this arrangement, the electrode terminal 4 is efficiently made in contact with the finger electrodes 31 by the use of the load of the auxiliary jig 60. Moreover, this arrangement makes it possible to prevent the solar 20 from being warped, damaged or the like, without any loads being applied from the electrode terminal 4 and the auxiliary jig 60 to the solar cell 20 in a shearing direction.

The load to be applied to the entire auxiliary jig 60 is preferably set to at least 350g or more, and preferably, to 1200g or more. When the entire load to be applied to the auxiliary jig 60 is less than 350g, the load becomes insufficient to make the electrode terminal 4 in contact with all the finger electrodes 31, possibly resulting in deviations for every measurements. Moreover, the upper limit of the entire load to be applied to the auxiliary jig 60 may be determined on demand depending on the durability of the solar cell 20 and the auxiliary jig 60.

In this case, the auxiliary jig 60 applies a load from the rear surface side of the solar cell 20 by using the probe pins 61; however, the load may be applied from the rear surface side of the solar cell 20 by using not the probe pins 61, but a jig having a rectangular plate shape.

Moreover, as shown in Fig. 15, in the auxiliary jig 60, the probe pins 61 may be used as terminals for use in measuring the current value and the voltage value. In this case, in each of the probe pins 61, the contact portion 61b is made in contact with the rear surface electrode 32 of the solar cell 20, and the plural pin main bodies 61a are allowed to protrude onto the lower surface 62b side of the holder 62 and coupled to one another by copper wires or the like, and then connected to the voltage measuring terminal plate 2 and the current measuring terminal plate 3 through the voltmeter 6 and the ampere meter 7.

Next, the following description will discuss an example in which electrical characteristics of the solar cell 20 were measured by using the auxiliary jig 60 in addition to the electrode terminal 4. In this example, the electrical characteristics of the solar cell 20 were measured, while the shape (probe pins/rectangular plate shape) of the auxiliary jig 60, the range (overall length/partial portion) of the solar cell 20 to be subjected to the load of the auxiliary jig 60 and the load to be applied to the entire portion of the auxiliary jig 60 were changed. The measurements were carried out five times under the respective conditions, and the average largest output value (Pmax) and the standard deviation (Pmaxσ) were calculated.

The process in which the load is applied to the overall length of the solar cell 20 by the auxiliary jig 60 refers to a process in which the load is applied to a region located 2 mm inside from each of the side edges of the solar cell 20, and the process in which the load is applied to the partial portion of the solar cell 20 refers to a process in which the load is applied to a region located 8 mm inside from each of the side edges of the solar cell 20. Moreover, the measurements of the respective photoelectric conversion efficiencies were conducted in compliance with JIS C8913 (Crystal-based Solar Cell Output Measuring Method) under conditions of an illuminance of 1000 W/m², a temperature of 25°C and a spectrum of AM 1.5G, by using a solar simulator (PVS1116i-M, made by Nisshinbo Mechatronics, Inc.).

In example 1, the auxiliary jig 60 with the probe pins 61 was used, and the current-voltage characteristic was measured while the entire load of 350g was being applied onto the overall length of the rear surface of the solar cell 20 of the busbarless type so that the largest output value was found.

In example 2, the measurements were carried out under the same conditions as those of example 1 except that the entire load to be applied to the auxiliary jig 60 was changed to 1250g.

In example 3, the measurements were carried out under the same conditions as those of example 1 except that the entire load to be applied to the auxiliary jig 60 was changed to 2100g.

In example 4, as shown in Fig. 17, an auxiliary jig 60 having an upper surface on which probe pins 61 and sponge pieces 63 were alternately formed was used. The dimensions of each sponge piece 63 were, for example, 10 mm (length), 5 mm (width) and 5 mm (height), and one of the sponge pieces and two of the probe pins 61 were alternately formed on the upper surface of the auxiliary jig 60. The other conditions were the same as those of example 1.

In example 5, an auxiliary jig 60 having a rectangular plate shape (flat plate) was used, and this was made in surface-contact with the rear surface of the solar cell 20, with a load being applied thereto. The other conditions were the same as those of example 2.

In example 6, a load was partially applied onto the solar cell 20. The other conditions were the same as those of example 2.

In example 7, a solar cell in which a plurality of finger electrodes 31 and busbar electrodes orthogonal to the finger electrodes 31 were formed was used, and electrical characteristics were measured, with the electrode terminal 4 being made in contact onto the busbar electrodes. The other conditions were the same as those of example 2. The average largest output value (Pmax) and the standard deviation (Pmaxσ) of example 7 form standard values that are used for making a good or bad determination on examples 1 to 6 for use in measuring the solar cells 20 of the busbarless type.

From the results of the measurements of the respective examples 1 to 7, the average largest output value (Pmax) and the standard deviation (Pmaxσ) were calculated. As the indexes for evaluation, in a case in which the average largest output value (Pmax) was 3.6 W or more, with the standard deviation (Pmaxσ) being set to less than 0.02, this case was regarded as an optimal level (○) for practical use, in a case in which the average largest output value (Pmax) was less than 3.6 W, with the standard deviation (Pmaxσ) being set to 0.02 or more, this case was regarded as a level (×) failing to be applied to practical use, and in a case in which the average largest output value (Pmax) was less than 3.6 W or the standard deviation (Pmaxσ) was 0.02 or more, this case was regarded as a level (Δ) in which no problem would be raised even when applied to practical use. Table 2 shows the results thereof.

**[Table 2]**

| | Example 1 | Example 2 | Example 3 | Example 4 | Example 5 | Example 6 | Example 7 |
|---|---|---|---|---|---|---|---|
| Shape of auxiliary jig | Probe | Probe | Probe | Probe/ Sponge | Flat plate | Probe | Probe |
| Range of auxiliary jig | Overal length | Overall length | Overall length | Overal length | Overal length | Partial length | Overall length |
| Total weight of auxiliary jig (g) | 350 | 1250 | 2100 | 1250 | 1250 | 1250 | 1250 |
| Busbar electrodes of cell | No | No | No | No | No | No | Yes |
| Output value of cell Pmax(W) | 3.55 | 3.80 | 3.81 | 3.80 | 3.56 | 3.69 | 3.80 |
| Deviations in cell output value Pmax(σ) | 0.061 | 0.018 | 0.019 | 0.018 | 0.08 | 0.026 | 0.017 |
| Determination | Δ | ○ | ○ | ○ | Δ | Δ | ○ |

As shown in Table 2, in the measuring methods using auxiliary jigs relating to examples 1 to 7, any of the results showed the optimal level for practical use or the level in which no problem would be raised even when applied to practical use.

When example 2 and example 1 were compared with each other, it was found that in example 1, since the total load was 350g, which was comparatively small, the contact between the electrode terminal 4 and the finger electrodes 31 became slightly insufficient. Consequently, it was found that the load to be applied to the auxiliary jig should be preferably set to 1200g or more.

When example 2 and example 4 were compared with each other, no difference was found in cell output values and deviations so that good results were obtained. Additionally, in accordance with embodiment 4, since the auxiliary jig having an upper surface on which the probe pins 61 and the sponge pieces 63 were alternately formed was used, the number of the probe pins 61 can be reduced, and maintenance operations required for exchanging pins can be simplified, thereby making it possible to reduce costs.

When example 2 and example 5 were compared with each other, since an auxiliary jig having a rectangular plate shape was used in example 5, the load applied to the auxiliary jig was not sufficiently transferred to the solar cell. This shows that it is preferable to allow the auxiliary jig to have a structure with probe pins.

In the case when example 2 and example 6 were compared with each other, since a load was partially applied to the solar cell in example 6, the contact between the electrode terminal 4 and the finger electrodes located near the side edge of the solar cell became insufficient. This shows that it is preferable to allow the auxiliary jig to apply the load over the overall length of the solar cell. Reference Signs List

1...solar cell output measuring device, 2...voltage measuring terminal plate, 3...current measuring terminal plate, 4...electrode terminal, 5...able, 6...voltmeter, 7...ampere meter, 8...insulating layer, 20... solar cell, 21...tab wire, 22...string, 23...matrix, 24...sheet, 25...surface cover, 26...back sheet, 27...metal frame, 28...solar cell module, 30... photoelectric conversion element, 31...finger electrode, 32...rear surface electrode, 33...conductive adhesive film, 34...tab wire connection portion, 36...conductive particles, 40...collector electrode, 41... solar cell, 41a...outside edge portion, 41b...thermal compression region, 41c...non-thermal compression region, 60...auxiliary jig, 61 probe pin, 62 holder.

## Claims

1. A solar cell output measuring device comprising:
a terminal plate made of a conductor that is made in contact with a plurality of finger electrodes formed on a surface of a solar cell,
wherein the terminal plate is allowed to intersect the finger electrodes so that the terminal plate is simultaneously made in contact with the plural finger electrodes; the terminal plate is connected to a measuring device for measuring electrical characteristics of the solar cell; and the terminal plate is formed into a rectangular shape, with one surface thereof being allowed to form a contact surface with the finger electrodes.

2. The solar cell output measuring device according to claim 1, wherein an electrode terminal having a pair of the terminal plates and an insulating layer that is installed between the paired terminal plates so as to insulate the terminal plates from each other is prepared; the paired terminal plates have main surfaces thereof that are made face to face with each other, with the insulating layer being interpolated between the main surfaces; and the one surface that is adjacent to the main surface through one side extending in the longitudinal direction is allowed to form a contact surface with the finger electrodes.

3. The solar cell output measuring device according to claim 1 or 2, wherein the terminal plate has at least a length corresponding to one side of the solar cell that is orthogonal to the finger electrodes.

4. The solar cell output measuring device according to any one of claim 2 and 3, wherein a pair of the electrode terminals are installed; the electrode terminals respectively have one of the terminal plates connected to an ampere meter, with the other terminal plate being connected to a voltmeter, so that electrical characteristics are measured by a 4-terminal method.

5. The solar cell output measuring device according to any one of claims 1 to 4, wherein the terminal plate is coated with a rust resistive material having conductivity.

6. The solar cell output measuring device according to any one of claims 1 to 5, wherein an auxiliary jig for use in sandwiching the solar cell in cooperation with the terminal plate is installed on a rear surface side of the solar cell.

7. The solar cell output measuring device according to claim 6, wherein the auxiliary jig is placed at a position opposed to the terminal plate, with the solar cell being interposed therebetween.

8. The solar cell output measuring device according to claim 6 or 7, wherein the auxiliary jig is provided with a plurality of probe pins that compress the entire width between two sides opposed to each other of the solar cell; and the entire jig has a load weight of 1200g or more.

9. A solar cell output measuring method comprising the steps of:
providing a solar cell output measuring device provided with a terminal plate made of a conductor and having a rectangular shape, which is connected to a measuring device for use in measuring electrical characteristics of a solar cell;
by placing one surface of the terminal plate on a plurality of finger electrodes formed on a surface of the solar cell so as to intersect the finger electrodes, making the terminal plate simultaneously in contact with the plural finger electrodes; and
while irradiating the surface of the solar cell with light, measuring electrical characteristics thereof.

10. The solar cell output measuring method according to claim 9, wherein an electrode terminal having a pair of the terminal plates and an insulating layer that is installed between the paired terminal plates so as to insulate the terminal plates from each other is prepared; the paired terminal plates have main surfaces thereof made face to face with each other, with the insulating layer being interpolated between the main surfaces; and the one surface that is adjacent to the main surface through one side extending in the longitudinal direction is allowed to form a contact surface with the finger electrodes.

11. The solar cell output measuring method according to claim 9 or 10, wherein in each of the solar cells, an adhesive region for a tab wire for use in connecting with another adjacent solar cell is formed as an inside region from the outside edge portion; a collector electrode that is formed in a region extended toward the outside edge portion from the region and intersects the plural finger electrodes formed on the outside edge portion is installed; and the terminal plate is made in contact onto the adhesive region for a tab wire and the collector electrode.

12. The solar cell output measuring method according to claim 10 or 11, wherein a pair of the electrode terminals are installed; the electrode terminals respectively have one of the terminal plate connected to an ampere meter, with the other terminal plate being connected to a voltmeter, so that electrical characteristics are measured by a 4-terminal method.

13. The solar cell output measuring method according to any one of claims 9 to 12, wherein the solar cell is sandwiched by an auxiliary jig formed on a rear surface side of the solar cell and the terminal plate.

14. The solar cell output measuring method according to claim 13, wherein the auxiliary jig is placed at a position opposed to the terminal plate, with the solar cell being interposed therebetween.

15. The solar cell output measuring method according to claim 13 or 14, wherein the auxiliary jig is provided with a plurality of probe pins that compress the entire width between two sides opposed to each other of the solar cell; and the entire jig has a load weight of 1200g or more.
